# FASCICULE DE BREVET EUROPEEN

(11) **EP 3 231 173 B1**
(45) Date de publication et mention de la délivrance du brevet: **07.11.2018**
(21) Numéro de dépôt: 15805511.1
(22) Date de dépôt: 08.12.2015
(51) Int. Cl.: H04N 5/341, H03K 5/135

(54) **PROCÉDÉ DE DISTRIBUTION SYNCHRONE D'UN SIGNAL NUMÉRIQUE SUR N BLOCS IDENTIQUES ADJACENTS D'UN CIRCUIT INTEGRÉ**
VEFAHREN ZUM SYNCHRONEN VERTEILEN EINES DIGITALEN SIGNALS AN N IDENTISCHE UND BENACHBART IN EINEM INTEGRIERTEN SCHALTKREIS ANGEORDNETE BLÖCKE
METHOD OF SYNCHRONOUS SIGNAL DISTRIBUTION IN N EQUAL BLOCKS LOCATED NEXT TO EACH OTHER IN AN INTEGRATED CIRCUIT

(30) Priorité: 11.12.2014 FR 1462253
(43) Date de publication de la demande: 18.10.2017
(73) Titulaire: Teledyne E2V Semiconductors SAS, 38120 Saint-Egrève (FR)
(72) Inventeur: DIASPARRA, Bruno, 38180 Seyssins (FR); BARBIER, Frédéric, 38120 Fontanil-Cornillon (FR)
(74) Mandataire: Desvignes, Agnès
(86) Numéro de dépôt international: PCT/EP2015/078994
(87) Numéro de publication internationale: WO 2016/091886

(56) Documents cités:
- US-A1- 2004 019 817
- US-A1- 2005 278 675
- US-B1- 6 874 097

## Description

### DOMAINE TECHNIQUE

L'invention concerne la distribution de signaux électriques, plus particulièrement numériques comme décrit par exemple dans les documents US 6 874 097 B1, US 2005/278675 A1 et US 2004/019817 A1, dans des circuits intégrés semi-conducteurs de grande dimension. Elle s'applique notamment aux capteurs d'image de grande dimension.

### CONTEXTE

La fabrication des circuits intégrés semi-conducteurs utilise des techniques de lithographie, plus particulièrement de photolithographie, pour réaliser les différents niveaux (couches) du circuit. A chaque niveau correspond un masque.

La taille maximum d'un circuit qu'il est possible de réaliser en une exposition est fixée par la taille maximale du champ d'exposition d'un masque, fixée par la taille du réticule, de l'ordre de 24 mm sur 30 mm, avec les techniques actuelles.

Pour réaliser des circuits de plus grande taille, on utilise une technique de lithographie dite à raccord de masques, permettant de couvrir l'intégralité de la surface du circuit à réaliser. Il s'agit alors de décomposer le schéma de conception du circuit en plusieurs morceaux élémentaires ; à chaque morceau élémentaire correspond un jeu de masques de lithographie. Lorsque le circuit comprend plusieurs morceaux élémentaires identiques, un unique jeu de masques est utilisé, en le repositionnant autant de fois que de répliques identiques à réaliser à la suite, suivant un axe rectangulaire du circuit.

Cette technique s'applique notamment à la réalisation des capteurs d'image de grande dimension, tels ceux utilisés dans le domaine de la vision industrielle ou du spatial. Notamment, la matrice de pixels de photodétection d'un capteur de grande dimension se prête à une telle décomposition en morceaux élémentaires identiques. Dans la suite on utilise la notion de bloc élémentaire, ou plus simplement "bloc", qui doit se comprendre au sens d'un schéma de conception (« design ») d'une fonction électronique donnée, c'est-à-dire d'un morceau de circuit identifié, avec des entrées de signal et des sorties de signal identifiées, qui sont respectivement des sorties et des entrées de signal d'autres blocs élémentaires, qui vont se raccorder les unes aux autres au fur et à mesure de la réalisation des blocs, par la technique de photolithographie dite à raccord de masques.

Pour rappel, un circuit électronique occupe une surface sensiblement rectangulaire d'une plaquette de semi-conducteur. La décomposition du circuit en blocs élémentaires est réalisée suivant les axes rectangulaires de cette surface. La photo-répétition de masques est réalisée suivant l'un et/ou l'autre de ces deux axes et les différents schémas de conception (design) des blocs élémentaires du circuit sont repérés suivant les deux axes rectangulaires. A un bloc, correspond un schéma de conception qui se traduit par un jeu de masques de lithographie, un masque par étape de réalisation du circuit. Chaque bloc s'inscrit également dans une surface rectangle repérée sur la plaquette, et la taille maximum de ce rectangle correspond à celle du réticule utilisé.

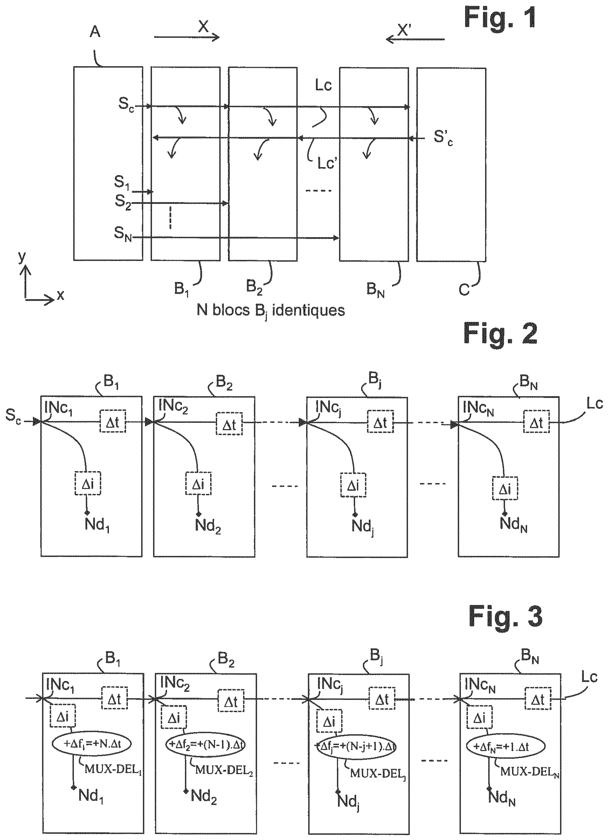

La figure 1 représente un exemple de décomposition en blocs élémentaires d'un circuit de grande dimension, suivant un axe x du circuit. On trouve successivement, de gauche à droite dans le plan de la feuille, un bloc A, une suite de N blocs identiques B et un autre bloc C. Par exemple, en reprenant l'exemple d'un capteur d'image, les blocs B peuvent correspondre à des ensembles de cellules de photodétection (pixels) de la matrice et les blocs périphériques A et C de chaque côté peuvent correspondre à des fonctions de fourniture de signaux numériques de contrôle ou d'adressage sur les pixels. Les masques sont définis avec une zone de recouvrement entre blocs successifs pour assurer la continuité des conducteurs sur lesquels transitent les signaux d'un bloc vers un autre. Ces aspects sont bien connus de l'homme du métier.

Le problème qui se pose dans ce contexte pour un circuit de grande dimension est qu'un signal numérique qui est appliqué sur chacun des N blocs identiques, par une ligne conductrice traversant ces N blocs, ne va pas arriver en même temps sur chacun de ces N blocs, du fait de la constante de temps de la ligne conductrice, en raison de sa longueur.

La figure 1 montre un signal S_{c} qui est fourni par le bloc A et appliqué sur chacun des N blocs B par une ligne de distribution électrique Lc, disposée parallèle à l'axe x. On peut avoir un autre signal S_{C}' fourni par le bloc C et appliqué sur les N blocs B par une autre ligne de distribution électrique Lc'.

Le signal S_{c} se propage suivant la direction X ; il arrive d'abord en entrée du premier bloc B, qu'il traverse, puis en entrée du deuxième bloc B, qu'il traverse et ainsi de suite jusqu'à l'arrivée en entrée du Nième bloc B. Dans chaque bloc, le signal S_{c} reçu sur une entrée du bloc est amené sur un noeud électrique interne du bloc, prévu pour ce signal. Cette amenée du signal depuis l'entrée du bloc vers le noeud interne est représentée par une flèche sur la figure. On note Δt la durée élémentaire de traversée d'un bloc B, depuis l'entrée d'un bloc B jusqu'à l'entrée du bloc B suivant ; et on note Δi, la durée élémentaire d'amenée du signal depuis l'entrée de signal S_{c}, jusqu'au noeud interne du bloc. Ces durées élémentaires sont des durées intrinsèques connues, qui ne dépendent que de la constante de temps et de la longueur des lignes de distribution et d'amenée de signal sur un bloc. On sait donc déterminer le moment d'arrivée du signal S_{c} sur le noeud interne de chacun des blocs, par rapport à un instant t₀ d'arrivée de ce signal sur l'entrée du premier bloc. Plus précisément et en référence aux figures 2 et 3, on note Bⱼ, le bloc de rang j dans la suite des N blocs, en partant de la gauche vers la droite, avec j entier variant de 1 à N ; INc_{j,} le point d'entrée sur ce bloc Bⱼ, de la ligne Lc distribuant le signal S_{c} ; et Ndⱼ le noeud interne du bloc Bⱼ sur lequel le signal S_{c} est amené. Et on note t₀ l'instant d'arrivée du signal S_{c} au point d'entrée INc₁ du bloc B₁.

Au point d'entrée INcⱼ, le signal S_{c} accuse un retard, par rapport à l'instant t₀, qui est égal à (j-1) fois Δt (traversée des j-1 blocs précédents), plus Δi (trajet entre INcⱼ et Ndⱼ). Dans ce retard, la composante en Δt n'est pas négligeable devant la période d'horloge du circuit. Par exemple, pour une longueur de ligne Lc entre les entrées de deux blocs identiques consécutifs égale à 20 mm (correspond à la largeur d'un bloc), la durée élémentaire Δt associée peut atteindre 5 nanosecondes avec les technologies actuelles. Dans un circuit travaillant à une fréquence horloge de 50 mégahertz, le retard cumulé du signal S_{c} en entrée du cinquième bloc, sera de l'ordre d'une période d'horloge, par rapport à l'instant t₀ d'arrivée sur le premier bloc. Dans le cas de N=5 blocs identiques consécutifs ou plus le signal S_{c} n'arrive pas dans la même période d'horloge dans les N blocs.

Ainsi, dans un circuit de grande dimension, qui peut comprendre au moins 8 à 10 blocs identiques consécutifs, le retard le long de la ligne de distribution sur une suite de N blocs élémentaires identiques n'est pas négligeable devant la fréquence horloge de travail du circuit et pose un problème de synchronisation des signaux/traitements de ces blocs.

### PROBLEME POSE

L'invention a pour objet de résoudre ce problème de synchronisation.

La problématique est double : on veut que les différents blocs élémentaires identiques reçoivent un signal numérique simultanément, c'est-à-dire dans la même période d'horloge ; et que ceci soit obtenu dans chacun des N blocs identiques, au moyen d'un circuit de gestion de délai qui conserve leur caractère identique.

Cette problématique concerne aussi bien le cas de la distribution d'un signal numérique tel que le signal S_{c} des figures 1 et 2, dont on souhaite qu'il soit appliqué simultanément sur chacun des N blocs consécutifs ; que celui de la distribution de N signaux numériques dont on souhaite que chacun soit appliqué sur un bloc respectif de la suite des N blocs, mais au même instant dans les N blocs. Le premier cas peut correspondre à un signal numérique commandant le fonctionnement des blocs, tels que les signaux de contrôle des différentes phases d'initialisation, intégration, transfert et lecture des pixels d'un capteur d'image ; et on veut que ces signaux arrivent tous en même temps sur chacun des blocs de la suite ; et le second cas peut correspondre à des signaux numériques qui sont des données ; et on veut que ces données soit chacune prise en compte ou traitée par un bloc respectif de la suite de N blocs, mais au même moment dans ces N blocs.

### RESUME DE L'INVENTION

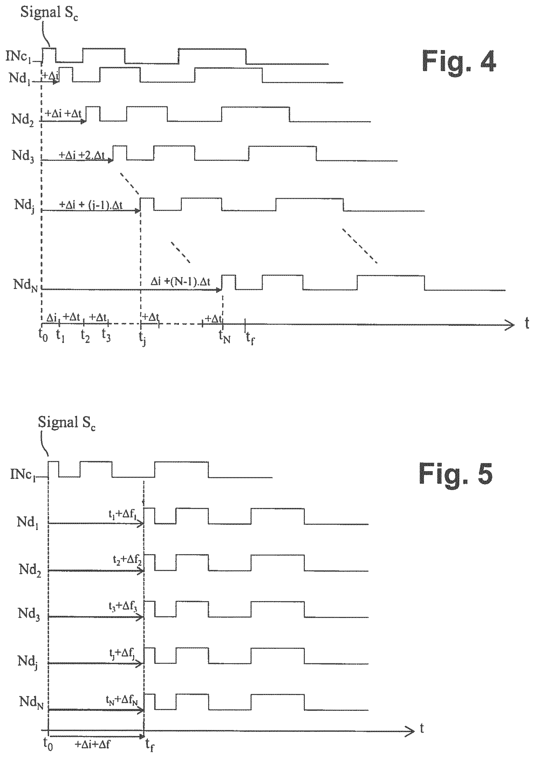

La constante de temps associée à la ligne Lc de distribution du signal S_{c} induit un étagement c'est-à-dire un décalage, qui est régulier, au pas Δt, du moment d'application sur le noeud interne des N blocs identiques de la suite, qui est illustré sur la figure 4. Si t₀ est l'instant de réception du signal S_{c} en entrée INc₁ du bloc B₁ : ce signal est reçu sur le noeud interne Nd₁ de ce bloc B₁ à t₁=Δi ; il est reçu un délai Δt plus tard, soit à t2=t₁+Δt=Δi +Δt, sur le noeud interne Nd₂ du bloc suivant B₂ ; il est reçu sur le noeud interne Ndⱼ du bloc Bⱼ à l'instant tⱼ=Δi +(j-1)Δt ; il est reçu sur le noeud interne Nd_{N} du bloc B_{N} à l'instant t_{N}=Δi +(N-1)Δt.

Dans l'invention, on veut s'affranchir de cet étagement. On veut que le signal S_{c} soit appliqué sur tous les noeuds internes en même temps, à l'instant t_{f}. Il s'agit de temporiser l'application du signal sur les noeuds internes au moins jusqu'à ce que le dernier bloc ait pu lui-même recevoir le signal sur le noeud interne. Mais il s'agit de réaliser cette temporisation dans chacun des N blocs identiques en conservant le caractère identique du schéma de conception des N blocs. C'est-à-dire que le circuit de temporisation doit pouvoir être réalisé dans ou pour chaque bloc, par photorépétition du même jeu unique de masques. Pour résoudre ce problème technique, l'invention propose de manière astucieuse de remplacer la durée élémentaire Δi d'amenée du signal sur le noeud interne, à l'intérieur de chaque bloc, qui est une durée intrinsèque au circuit, négligeable devant la fréquence de travail du circuit, par une durée déterminée, qui est imposée par un circuit de temporisation placé sur le chemin d'amenée du signal depuis l'entrée du bloc sur le noeud interne du bloc ; de prévoir que le circuit de temporisation fournissent N signaux retardés correspondant à N temporisations différentes séparées par un incrément de durée élémentaire Δt ; et de sélectionner le signal retardé correspondant à la temporisation applicable fonction du bloc concerné, au moyen d'un signal d'index propagé à travers les N blocs, et qui s'incrémente ou se décrémente au passage dans chaque bloc.

Le circuit de temporisation conçu selon l'invention s'applique ainsi à chacun des blocs quelque soit son rang : c'est la valeur de l'index dans le bloc considéré qui va particulariser la sortie du circuit de temporisation de ce bloc. Typiquement, le bloc B₁ aura la temporisation de signal S_{c} la plus longue ; le bloc B_{N} aura la temporisation de signal S_{c} la plus courte.

Ce circuit de temporisation peut ainsi être réalisé pour chacun des N blocs Bⱼ en utilisant le même jeu de masques. Ce jeu de masques peut en pratique être celui défini pour le bloc B lui-même lorsque le circuit de temporisation est intégré au circuit du bloc B ; ou un jeu de masques propre, lorsque le circuit de temporisation entre dans la définition d'un autre bloc élémentaire de circuit, par exemple un bloc qui regroupe la pluralité de circuits de temporisation pour temporiser la pluralité de signaux à distribuer sur les blocs B.L'invention concerne ainsi un procédé de distribution de signal numérique à chacun des blocs d'une suite alignée de N blocs identiques adjacents d'un circuit électronique, par des lignes conductrices de signal traversant les N blocs suivant l'axe d'alignement des blocs, la traversée de chacun des N bloc introduisant un retard élémentaire Δt, et un circuit électronique correspondant.

L'invention est caractérisée par
- une indexation automatique des blocs par propagation d'un signal d'index à travers les N blocs, avec incrémentation ou décrémentation de la valeur d'index au passage dans chaque bloc, ladite indexation automatique établissant une valeur d'index respective pour chacun des N blocs de la suite,
- une temporisation de signal appliquée en entrée de chaque bloc, entre une ligne conductrice d'un signal et un noeud électrique interne d'application dudit signal, et la durée de temporisation appliquée est sélectionnée par la valeur d'index établie pour ce bloc, parmi N durées de temporisation différentes séparées par un incrément de durée élémentaire Δt qui correspond au retard élémentaire Δt de traversée d'un bloc introduit dans une ligne conductrice,
et cette temporisation est mise en oeuvre au moyen d'un circuit de temporisation par bloc, qui est identique pour chaque bloc, qui est connecté entre l'entrée et le noeud interne du bloc, et qui comprend N circuits à retard pour fournir les N durées de temporisation, lesdits circuits à retard étant chacun connectés entre l'entrée du bloc et une voie d'entrée respective d'un multiplexeur à N voies d'entrée et une voie de sortie, ladite voie de sortie étant connectée au noeud interne du bloc, et ladite valeur d'index établie pour le bloc étant appliquée au multiplexeur comme entrée de sélection de voie d'entrée, ledit procédé étant tel que pour tout j, j entier de 1 à N, un signal numérique transmis par une ligne conductrice respective et reçu en entrée du j-ième bloc de la suite après avoir traversé les j-1 blocs précédents de la suite, est appliqué sur le noeud interne de ce bloc avec une temporisation supérieure de Δt à la temporisation correspondante dans le (j+1)ième bloc ou inférieure de Δt à la temporisation correspondante dans le (j-1)ième bloc.

Dans une application à la distribution M signaux numériques, M entier au moins égal à 1, où chacun des M signaux numériques est distribué sur un noeud électrique interne correspondant dans chacun des N blocs de la suite, M circuits de temporisation identiques sont prévus dans chacun des N blocs, recevant le signal d'index sélectionnant un retard parmi N retards.

Dans une application à la distribution de N signaux numériques par N lignes conductrices traversant les N blocs de la suite, où chacun des N signaux numériques est appliqué à un noeud électrique interne d'un seul bloc respectif de la suite des N blocs, on prévoit en outre un routage des N signaux à l'intérieur de chaque bloc, identique pour chaque bloc, entre N plots d'entrée et N plots de sorties du bloc, les plots d'entrée et de sortie de routage de même rang étant alignés sur les N blocs, et les N plots de sortie d'un bloc étant connectés aux N plots d'entrée du bloc suivant, en correspondance, ledit routage à l'intérieur de chaque bloc étant tel que :
- un premier plot d'entrée du bloc est connecté en entrée d'un circuit de temporisation du bloc ;
- les N-1 autres plots d'entrée du bloc sont connectés aux N-1 premiers plots de sortie du bloc tel que le plot d'entrée ayant le rang k, où k=2 à N, est connecté au plot de sortie de rang k-1 ; et
- le N-ième plot de sortie de routage du bloc est référencé à une référence interne de tension.

Dans une mise en oeuvre de l'invention, le signal d'index est incrémenté d'une unité au passage dans chaque bloc quand il est propagé dans le même sens que le ou les signaux numériques, ou décrémenté d'une unité quand il est propagé dans le sens inverse.

D'autres caractéristiques et avantages de l'invention sont présentés dans la description suivante, en référence aux dessins annexés dans lesquels :
- la figure 1 déjà décrite montre de manière schématique une décomposition d'un morceau de circuit en une rangée de blocs successifs, comprenant une suite de N blocs identiques entre deux blocs périphériques ;
- la figure 2 déjà décrite illustre les durées élémentaires intrinsèques Δt, de traversée d'un bloc et Δi, d'amenée de signal sur un noeud interne du bloc ;
- la figure 3 illustre le principe selon l'invention de temporisation de l'application du signal à l'intérieur de chaque bloc en fonction du rang du bloc ;
- la figure 4 est un chronogramme illustrant le décalage temporel des instants de réception d'un signal S_{c} distribué sur la suite des N blocs identiques de la figure 1 ;
- la figure 5 est un chronogramme illustrant le principe de temporisation selon l'invention permettant de synchroniser l'instant de réception du signal S_{c} dans les N blocs ;
- la figure 6 illustre une suite de N blocs identiques intégrant chacun un circuit de temporisation de signal selon l'invention ;
- la figure 7 détaille un circuit de temporisation selon l'invention ;
- la figure 8 illustre une application de l'invention à la temporisation de plusieurs signaux différents devant être appliqués chacun simultanément à chacun des N blocs ; et
- la figure 9 illustre une autre application de l'invention, à la temporisation de N signaux différents, chaque signal devant être appliqué au même moment à un bloc respectif parmi les N blocs identiques de la suite.

### DESCRIPTION DETAILLEE

Dans l'invention, on prévoit pour chaque bloc, un circuit de temporisation d'un signal numérique, de conception identique pour chaque bloc. Le circuit est conçu pour retarder l'instant d'application sur un noeud interne correspondant, d'un signal reçu en entrée du bloc, d'une durée déterminée, qui est fonction du rang du bloc dans la suite des N blocs identiques. L'expression "noeud interne" signifie le point d'application de ce signal à un élément de ce bloc, sur lequel le signal déclenche ou produit un effet attendu correspondant (cas d'un signal de commande) ; ou bien qui traite ce signal (cas d'un signal de donnée).

La figure 5 illustre de manière simplifiée la fonction du circuit de temporisation selon l'invention, par lequel le signal S_{c} arrive au même instant t_{f} sur le noeud interne Ndⱼ de chacun des N blocs de la suite. Cet instant t_{f} est égal à t₀+Δi+Δf, c'est-à-dire que le signal S_{c} arrive sur tous les noeuds internes avec un même retard Δi+Δf par rapport à l'instant t₀ d'arrivée du signal en entrée du premier bloc, et ceci en conservant le caractère identique des N blocs.

Selon l'invention, le circuit de temporisation est conçu pour imposer dans chacun des N blocs, un retard supplémentaire dont la durée est modulaire, fonction du rang j du bloc dans la suite des N blocs et fonction de la durée intrinsèque élémentaire Δt de traversée d'un bloc. On note Δfⱼ cette durée de temporisation modulaire, fonction du rang du bloc. Pour N blocs identiques, on a N durées de temporisation différentes Δf₁, ...Δfⱼ... Δf_{N}, et ces durées sont séparées d'un incrément de durée élémentaire Δt qui correspond au retard élémentaire Δt de traversée d'un bloc introduit dans une ligne conductrice.

L'invention est décrite plus en détails ci-après, en prenant en exemple une mise en oeuvre dans laquelle le circuit de temporisation est conçu pour retarder volontairement l'arrivée du signal S_{c} sur le noeud interne du bloc Bⱼ de rang j, d'une durée Δfⱼ égale à (N-j+1) fois le délai intrinsèque élémentaire Δt.

La figure 3 illustre l'effet dans chaque bloc Bⱼ, d'un circuit de temporisation du signal S_{c} correspondant, selon le rang j du bloc considéré : dans le premier bloc de rang 1 (j=1), le circuit de temporisation MUX-DEL₁ ajoute un délai Δf₁ égal à N.Δt. Dans le bloc de rang j, le circuit de temporisation MUX-DELⱼ ajoute un délai Δfⱼ égal à (N-j+1).Δt. Dans le bloc de rang N (j=N), le circuit de temporisation MUX-DEL_{N} ajoute un délai Δf_{N} égal à 1.Δt.

Au final le signal S_{c} arrive en tous les noeuds Nd₁, Nd₂, ...Nd_{N} au même instant t_{f} (figures 3 et 5).

A ce retard modulaire volontairement imposé dans chacun des blocs par le circuit de temporisation de l'invention, s'ajoute un retard interne "intrinsèque", lié aux caractéristiques des éléments de ligne de conduction avant et/ou après le circuit de temporisation, ou entre les éléments de circuits constituant le circuit de temporisation. Pour ne pas multiplier les références, on continue de noter ce retard intrinsèque Δi ; la durée de ce retard intrinsèque Δi reste négligeable devant la durée intrinsèque Δt de traversée de bloc et donc a fortiori devant le retard modulaire Δfⱼ volontaire ajouté par le circuit de temporisation, qui est un multiple de Δt.

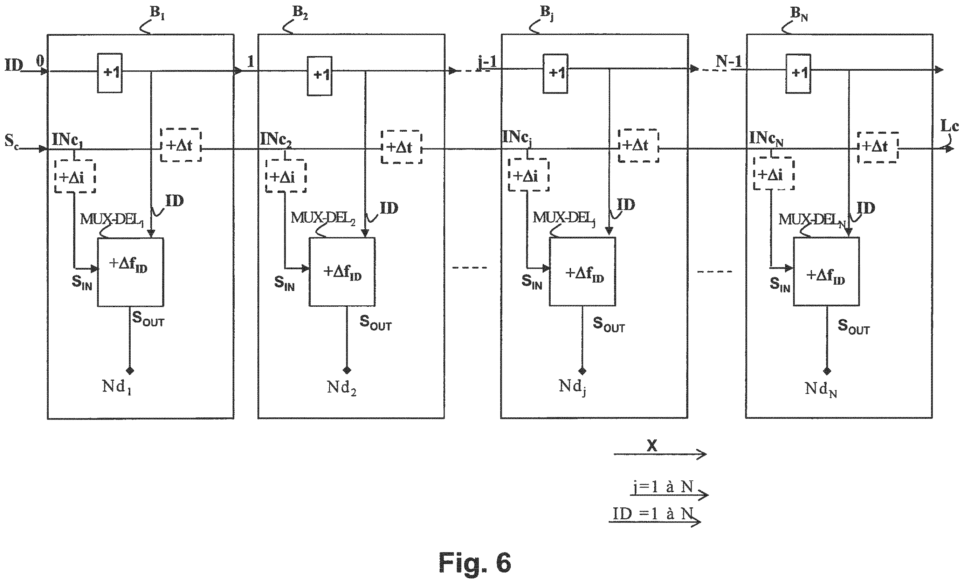

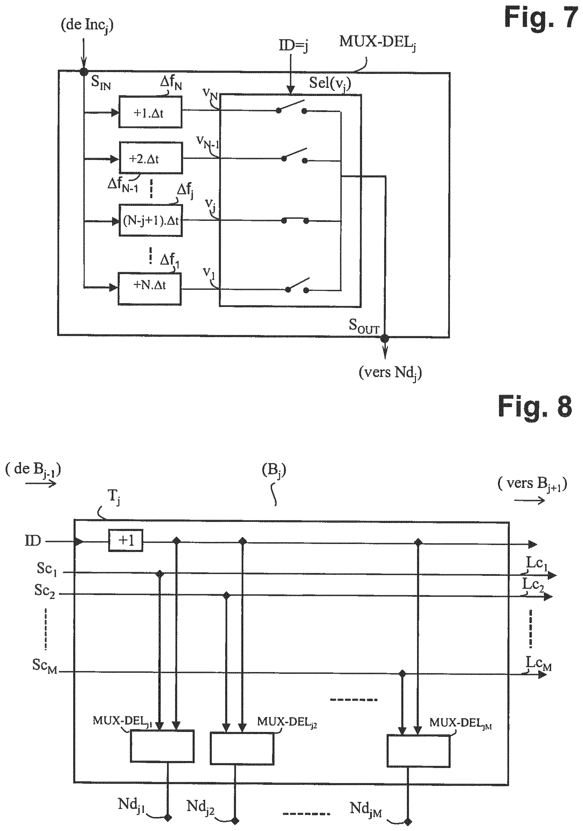

Un circuit de temporisation selon l'invention est maintenant décrit en relation avec les figures 6 et 7. On note Δf_{ID} le retard modulaire ajouté par le circuit de temporisation dans le bloc concerné, et ID, un signal d'index qui est propagé à travers les N blocs en s'incrémentant ou en se décrémentant au passage dans chaque bloc selon que l'index se propage dans le même sens que le signal auquel on applique la temporisation ou en sens inverse. Dans les figures 6 et 7, le signal d'index ID est propagé dans le même sens que le signal S_{c} ; il s'incrémente d'une unité (+1) dans chaque bloc, par exemple au moyen d'un additionneur.

Le signal d'index est une donnée numérique codée sur quelques bits. Si le nombre N de blocs de la suite est égal à 10, 4 bits suffisent. Ce signal est représenté par une ligne de distribution sur les figures ; mais cette ligne comprend en pratique autant de conducteurs que de bits de données. Ce signal d'index est appliqué au premier bloc avec une valeur initiale. Dans l'exemple cette valeur initiale est zéro (0). Cette valeur est incrémentée en entrée du bloc et c'est cette valeur incrémentée qui est appliquée en entrée de sélection Sel(vᵢ) du circuit de temporisation du bloc et qui est transmise en entrée du bloc suivant. Ainsi, avec les conventions retenues dans cet exemple, la valeur d'index ID qui est utilisée pour la sélection du retard modulaire dans le circuit de temporisation, varie de 1 à N, comme le rang j du bloc, dans le sens de propagation du signal S_{c}.

Le signal d'index ID est établi sur (pour) tous les blocs pour permettre la sélection du retard applicable dans chaque bloc. Par exemple cet établissement du signal d'index est réalisé pendant une phase d'initialisation du circuit électronique.

Une mise en oeuvre de l'invention est plus particulièrement expliquée en référence aux figures 6 et 7, avec les conventions de notation et de sens de propagation indiquées ci-dessus. D'autres mises en oeuvre basées sur d'autres conventions sont possibles, sans sortir du cadre de l'invention. Par exemple, on peut appliquer la valeur d'index reçue en entrée du bloc, en entrée de sélection sur le circuit de temporisation du bloc, et transmettre la valeur incrémentée de cet index au bloc suivant. Dans ce cas la valeur ID utilisée en sélection varie de 0 à N-1. On peut aussi propager la valeur d'index dans le sens inverse de propagation du signal. Un exemple correspondant sera donné plus loin.

Reprenons donc les figures 6 et 7. Un circuit de temporisation selon l'invention est implanté dans chacun des N blocs de la suite. On a ainsi N circuits, notés MUX-DELⱼ, avec j entier variant de 1 à N, tous strictement identiques, réalisés (réalisables) à partir du même jeu de masques de photolithographie.

Le circuit de temporisation MUX-DELⱼ selon l'invention comprend (figure 7) N circuits à retard en parallèle et un multiplexeur à N voies d'entrées vers une voie de sortie ; la sortie de chaque circuit à retard est reliée à une voie d'entrée respective du multiplexeur. Et le circuit de temporisation présente deux entrées et une sortie de signal en interface avec le bloc :
- une entrée de signal, S_{IN}, reliée à l'entrée INcⱼ du bloc, par laquelle le signal S_{c} est appliqué en entrée des N circuits à retard ;
- une entrée de sélection notée Sel(vⱼ), permettant la sélection de la voie d'entrée du multiplexeur à relier à la voie de sortie du multiplexeur ; cet entrée Sel(vⱼ) reçoit le signal d'index ID;
- une sortie de signal, Sₒᵤₜ, qui correspond à la voie de sortie du multiplexeur, reliée au noeud interne Ndⱼ du bloc, qui est le noeud d'application du signal S_{c} dans le bloc.

Les N circuits à retard sont respectivement chacun configurés pour retarder le signal S_{c} reçu en entrée du bloc, d'une durée différente, dans l'exemple, respectivement 1 fois, 2 fois, ...j fois, ...N fois la durée élémentaire Δt de traversée d'un bloc.

Ces N circuits à retard sont disposés chacun entre l'entrée de signal INcⱼ du bloc et une voie respective parmi les N voies d'entrée v1, v2, ....v_{N} du multiplexeur. Ces circuits à retard sont chacun réalisés en pratique par une ligne à retard analogique, par inverseurs cascadés, ou encore par réseaux RC, dimensionnés de manière appropriée pour obtenir le retard modulaire souhaité.

Selon l'invention, le signal d'index ID appliqué comme signal de sélection de voie Sel(vⱼ) en entrée du multiplexeur permet de sélectionner dans chaque bloc la voie d'entrée du multiplexeur qui correspond à la temporisation qui doit être appliquée au signal S_{c} reçu en entrée du bloc considéré, en fonction du rang j du bloc, relativement au sens de propagation du signal S_{c} sur les N blocs (avec j croissant de 1 à N dans le sens de propagation du signal S_{c}). Dans l'exemple, la temporisation appliquée par le circuit de temporisation du bloc de rang j est égale à (N-j+1) fois Δt.

Dans l'exemple de mise en oeuvre illustré sur les figures 6 et 7, la valeur utile du signal d'index ID (celle appliquée comme entrée de sélection Sel(vⱼ)), varie comme j, c'est-à-dire de 1 à N, dans le sens de propagation du signal S_{c}. Dans l'exemple, on note v₁, ....v_{N} les N voies d'entrée du multiplexeur ; v₁ correspond à la voie la plus retardée, avec une temporisation imposée par le circuit à retard correspondant, ici égale à +N.Δt et v_{N} correspond à la voie la moins retardée, avec une temporisation imposée par le circuit à retard correspondant, ici égale à +Δt. Pour le bloc de rang j, le signal d'index ID est établi à la valeur j sur l'entrée de sélection Sel(vⱼ) du circuit MUX-DELⱼ ce qui sélectionne la voie vⱼ, fournissant un signal retardé d'une durée ici égale à +(N-j+1)+Δt.

Si le signal d'index est établi dans les N blocs en partant du bloc N, c'est-à-dire par propagation en sens inverse du signal S_{c} ; dans cette hypothèse le signal d'index est propagé en se décrémentant d'une unité dans chaque bloc, à partir d'une valeur initiale, par exemple égale à N. Les voies d'entrée du multiplexeur seraient alors reliées aux sorties des N circuits à retard dans l'ordre inverse de celui qui est illustré sur la figure 7 : la 1^{ère} voie v₁ correspondrait au retard le plus court, +1.Δt, et la Nième voie v_{N}, au retard le plus long, +N.Δt, pour permettre la sélection la voie d'entrée appropriée à appliquer en sortie Sₒᵤₜ du circuit en fonction du signal d'index.

Ces considérations pratiques de mise en oeuvre en fonction de la valeur initiale du signal d'index, du sens de propagation du signal, de la prise en compte avant ou après incrémentation ou décrémentation, et en considération des adresses des N voies d'entrée du multiplexeur sont des variantes usuelles pour l'homme de l'art. Ainsi l'invention ne se limite pas aux mises en oeuvre plus particulièrement illustrées.

Dans tous les cas notamment, un signal d'index est fourni avec une valeur initiale, par exemple par un bloc périphérique tel que le bloc A ou C de la figure 1, et propagé sur les N blocs à travers un circuit numérique, additionneur ou soustracteur, prévu dans chacun des N blocs, permettant d'établir la valeur d'index utile correspondante pour chacun de ces N blocs.

La figure 8 illustre une application de l'invention à la temporisation de plusieurs signaux distincts, par exemple des signaux de commande de différentes phases opérationnelles des blocs ; chacun distribué par une ligne de distribution respective, suivant le même sens de propagation X, sur les N blocs de la suite ; et chacun appliqué sur un noeud interne respectif dans chacun des N blocs. Dans l'exemple, les M signaux Sc₁, Sc₂, Sc_{M} sont distribués chacun par une ligne respective Lc₁, Lc₂, ...Lc_{M}, sur chacun des N blocs de la suite.

Selon l'invention, on prévoit dans chaque bloc Bⱼ, un étage de temporisation Tⱼ qui comprend autant de circuits de temporisation identiques, que de signaux différents à appliquer en interne. Dans l'exemple chaque étage de temporisation Tⱼ comprend M circuits de temporisation notés MUX-DELⱼ₁, ...MUX-DEL_{jM} qui sont tous commandés par le même signal d'index ID ; chacun reçoit un des M signaux reçus en entrée de bloc, et fournit un signal temporisé correspondant en sortie, sur un noeud interne correspondant du bloc (Ndⱼ₁, Ndⱼ₂, ....Nd_{jM}).

L'invention permet ici que chacune des différentes phases commandées par les différents signaux de commande soit activée en même temps dans chaque bloc.

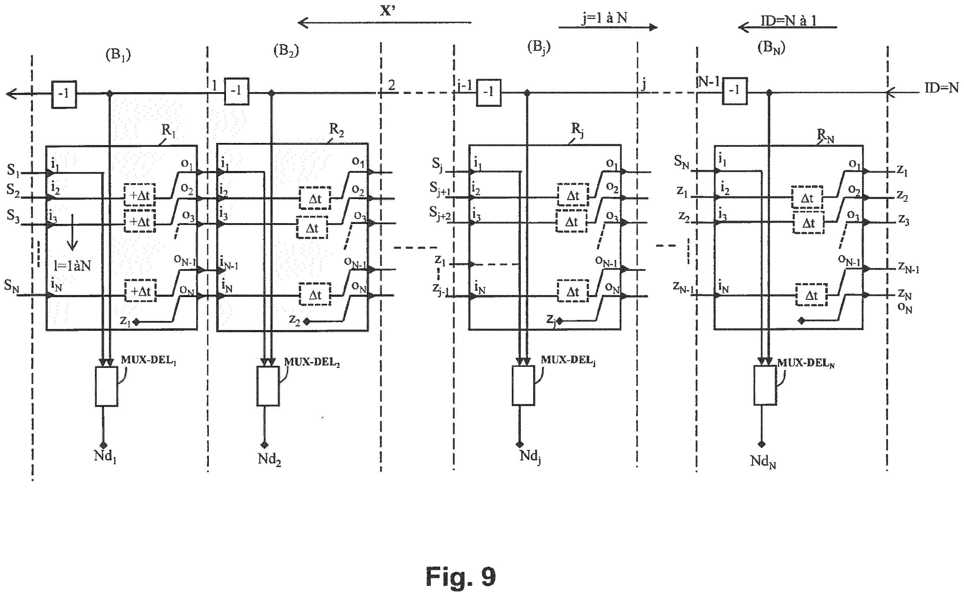

La figure 9 illustre un autre exemple d'application de l'invention. Il s'agit ici de distribuer N signaux différents, suivant le même sens de propagation, mais chacun sur un seul bloc. On souhaite ici que ces N signaux soient pris en compte ou traités dans leur bloc respectif au même instant t_{f} (dans la même période). Ces N signaux sont par exemple des signaux de données sortant eux-mêmes de N blocs identiques de circuits, par exemple de N blocs de pixels d'un capteur d'image. Ce que l'on recherche ici, c'est à synchroniser le traitement de ces N signaux de données, dans N blocs de traitement de données identiques.

On prévoit ainsi un circuit de temporisation de signal par bloc ; les N circuits de temporisation reçoivent tous le signal d'index ID, propagé avec décrémentation d'un bloc au suivant, et sont activés par ce signal pour sélectionner le retard comportant le multiple de Δt qui convient à chaque bloc.

On prévoit en outre un circuit de routage interne des N signaux dans chaque bloc, à N plots d'entrée i₁ à i_{N} et N plots de sorties o₁ à o_{N}, et le circuit de routage est identique quelque soit le bloc : le dessin des tracés des connexions reliant les N plots d'entrée et les N plots de sortie sont identiques. Plus précisément :
Chaque plot d'entrée est aligné sur le plot de sortie de même rang, suivant la direction X de propagation du signal. Chacun des N plots de sortie du circuit de routage d'un bloc est relié au plot d'entrée de même rang du circuit de routage du bloc suivant. Les rangs des plots varient ici suivant l'axe orthogonal à l'axe de propagation du signal. Dans l'exemple, le rang des plots croit suivant l'axe Y orienté vers le bas de la feuille. Il pourrait varier dans le sens inverse.

Le signal reçu sur le premier plot d'entrée i₁, de rang 1, est routé vers le circuit de temporisation du bloc concerné ; les signaux reçus sur le deuxième, troisième, ..., kième,...Nième plot d'entrée du circuit d'aiguillage, sont respectivement routés vers le premier, deuxième, troisième, ... (k-1)ième, ...(N-1)ième plot de sortie du circuit de routage du bloc. Le Nième plot de sortie du circuit de routage est relié à une référence de tension, typiquement la masse, qui constitue un premier signal factice z₁ qui va être propagé de bloc en bloc, en se décalant d'un rang de plot d'entrée à chaque bloc, pour finalement être appliqué sur le premier plot d'entrée du circuit de routage R_{N} du dernier bloc, B_{N}. Dans chaque bloc, un nouveau signal factice est généré et appliqué sur le dernier plot de sortie o_{N} du circuit de routage concerné. En pratique, dans cet exemple, le routage du signal reçu sur le premier plot d'entrée i₁ vers le circuit de temporisation est effectué sur un niveau conducteur du circuit différent du niveau conducteur sur lequel sont effectués les autres routages.

Si on considère le bloc Bⱼ de rang j : le circuit Rⱼ de routage du bloc Bⱼ reçoit le signal Sⱼ, destiné au noeud interne Nd_{N} de ce bloc, sur le premier plot d'entrée i₁ et l'applique sur le circuit de temporisation MUX-DELⱼ ; il reçoit les (N-j) signaux restant à distribuer, Sⱼ₊₁ à S_{N}, sur les plots d'entrée respectifs i₂ à i_{N-j+1} qu'il route respectivement sur les plots de sortie o₁ à o_{N-j} ; il reçoit j-1 signaux factices z₁ à zⱼ₋₁ sur les plots d'entrée restants i_{N-j+2} à i_{N} qu'il route respectivement sur les plots de sortie o_{N-j+1} à o_{N-1} ; il génère un jième signal factice zⱼ qu'il amène sur le plot de sortie o_{N}.

Le circuit de routage R_{N} du dernier bloc reçoit ainsi sur le premier plot d'entrée i₁, le signal S_{N} destiné au noeud interne Nd_{N} de ce bloc, et sur les autres plots d'entrée i₂ à i_{N}, il reçoit N signaux factices z₁ à z_{N-1}. Il fournit en sorties o₁ à o_{N}, N signaux factices z₁ à z_{N}.

La combinaison d'un tel circuit de routage à un circuit de temporisation, identiques quelque soit le bloc, avec un signal d'index ID selon l'invention permet donc d'appliquer simultanément, de façon synchrone, un signal différent sur chacun des N blocs de la suite.

On note que dans l'exemple de la figure 9, on a illustré l'exemple d'un signal d'index ID propagé dans le sens inverse des signaux S₁ à S_{N}. Dans l'exemple il a une valeur initiale établie à N en entrée du bloc B_{N}, et est décrémenté au passage dans chaque bloc. Une propagation en sens direct avec incrémentation de l'index pourrait être prévue comme à la figure 6.

Cette incrémentation (ou décrémentation) du signal d'index est par exemple, réalisée au moyen d'un additionneur (d'un soustracteur). Dans un autre exemple non limitatif, on utilise une table de multiplexage codée avec les N valeurs d'index possibles en entrées, et telle que la valeur d'index ID reçu par le bloc, sélectionne comme valeur de sortie de la table, la valeur d'index avec l'incrément ou le décrément voulu parmi les N valeurs disponibles.

Enfin, dans tout ce qui précède, on a considéré pour des raisons pratiques que le retard établi par le circuit de temporisation du bloc de dernier rang est Δt. Mais ce retard pourrait être nul, ou même quelconque, pourvu que le retard du bloc précédent diffère de Δt par rapport au dernier bloc, et que le retard de n'importe quel bloc (Bⱼ) diffère de +Δt par rapport au retard du bloc suivant (Bⱼ₊₁) et de -Δt par rapport au retard du bloc précédent (Bⱼ₋₁).

L'invention dont quelques exemples de mise en oeuvre et d'application viennent d'être expliqués, s'applique tout particulièrement à des circuits de grande taille, réalisés par des techniques de raccord de masques, dont un ou des morceaux du schéma de conception peuvent être découpés en une suite de blocs identique suivant un des axes rectangulaires du circuit. Elle permet de synchroniser automatiquement de manière astucieuse, les moments d'application des signaux sur des noeuds internes de ces blocs, en conservant leur caractère identique.

## Revendications

1. Procédé de distribution de signal numérique à chacun des blocs d'une suite alignée de N blocs identiques adjacents d'un circuit électronique, par des lignes conductrices de signal traversant les N blocs suivant l'axe d'alignement des blocs, la traversée de chacun des N bloc introduisant un retard élémentaire Δt, **caractérisé en ce que** le procédé comprend
- une indexation automatique des blocs par propagation d'un signal d'index (ID) à travers les N blocs, avec incrémentation ou décrémentation de la valeur d'index au passage dans chaque bloc, ladite indexation automatique établissant une valeur d'index respective pour chacun des N blocs de la suite,
- une temporisation de signal appliquée en entrée de chaque bloc, entre une ligne conductrice d'un signal et un noeud électrique interne d'application dudit signal, et la durée de temporisation appliquée est sélectionnée par la valeur d'index établie pour ce bloc, parmi N durées de temporisation différentes séparées par un incrément de durée élémentaire Δt qui correspond au retard élémentaire Δt de traversée d'un bloc introduit dans une ligne conductrice,
et **en ce que** cette temporisation est mise en oeuvre au moyen d'un circuit de temporisation par bloc, qui est identique pour chaque bloc, qui est connecté entre l'entrée et le noeud interne du bloc, et qui comprend N circuits à retard pour fournir les N durées de temporisation, lesdits circuits à retard étant chacun connectés entre l'entrée du bloc et une voie d'entrée respective d'un multiplexeur à N voies d'entrée et une voie de sortie, ladite voie de sortie étant connectée au noeud interne du bloc, et ladite valeur d'index établie pour le bloc étant appliquée au multiplexeur comme entrée de sélection de voie d'entrée (Sel(vⱼ), ledit procédé étant tel que pour tout j, j entier de 1 à N, un signal numérique transmis par une ligne conductrice respective et reçu en entrée (INcⱼ) du j-ième bloc (Bⱼ) de la suite après avoir traversé les j-1 blocs précédents de la suite, est appliqué sur le noeud interne de ce bloc avec une temporisation supérieure de Δt à la temporisation correspondante dans le (j+1)ième bloc ou inférieure de Δt à la temporisation correspondante dans le (j-1)ième bloc.

2. Procédé de distribution selon la revendication 1, appliqué à la distribution de M signaux numériques, M entier au moins égal à 1, où chacun des M signaux numériques est distribué sur un noeud électrique interne correspondant dans chacun des N blocs de la suite, **caractérisé en ce que** la temporisation de chacun des M signaux numériques dans chacun des N blocs de la suite est réalisée par M circuits de temporisation identiques dans chacun des N blocs, recevant le signal d'index (ID) sélectionnant un retard parmi N retards.

3. Procédé de distribution selon la revendication 1, appliqué à la distribution de N signaux numériques par N lignes conductrices traversant les N blocs de la suite, où chacun des N signaux numériques est appliqué à un noeud électrique interne d'un seul bloc respectif de la suite des N blocs, **caractérisé en ce qu'**il comprend en outre un routage des N signaux à l'intérieur de chaque bloc, identique pour chaque bloc, entre N plots d'entrée i₁ à i_{N} et N plots de sorties o₁ à o_{N} du bloc, les plots d'entrée et de sortie de routage de même rang étant alignés sur les N blocs, et les N plots de sortie d'un bloc étant connectés aux N plots d'entrée du bloc suivant, en correspondance, ledit routage à l'intérieur de chaque bloc étant tel que :
- un premier plot d'entrée (i₁) du bloc est connecté en entrée d'un circuit de temporisation du bloc ;
- les N-1 autres plots d'entrée du bloc (i₂ à i_{N}) sont connectés aux N-1 premiers plots de sortie du bloc (o₁ à o_{N-1}), tel que le plot d'entrée ayant le rang k, où k=2 à N, est connecté au plot de sortie de rang k-1 ; et
- le N-ième plot de sortie (o_{N}) de routage du bloc est référencé à une référence interne de tension.

4. Procédé selon l'une des revendications 1 à 3, dans lequel le signal d'index est incrémenté d'une unité au passage dans chaque bloc quand il est propagé dans le même sens que le ou les signaux numériques, ou décrémenté d'une unité quand il est propagé dans le sens inverse.

5. Circuit électronique comportant au moins une suite alignée de N blocs identiques adjacents et une ou des lignes conductrices traversant les N blocs suivant l'axe d'alignement des blocs, qui permettent d'appliquer au moins un signal numérique sur une entrée de chacun des N blocs de la suite en vue de transmettre ce signal sur un noeud électrique interne respectif du bloc, **caractérisé en ce que** chaque bloc comprend
- une entrée de signal d'index pour recevoir un signal d'index (ID) et le propager à travers les N blocs, avec incrémentation ou décrémentation de la valeur d'index au passage dans le bloc, pour établir une valeur d'index respective pour chacun des N blocs de la suite,
- un circuit de temporisation de signal par bloc, identique pour chaque bloc, et connecté entre l'entrée du bloc et le noeud électrique interne du bloc, le circuit de temporisation comprenant N circuits à retard pour fournir une série de N durées de temporisation différentes séparées par un incrément de durée élémentaire Δt qui correspond au retard élémentaire Δt de traversée d'un bloc introduit dans une ligne conductrice,
les N circuits à retard étant chacun connectés entre l'entrée du bloc et une voie d'entrée respective d'un multiplexeur à N voies d'entrée et une voie de sortie, ladite voie de sortie étant connectée au noeud interne du bloc, et ladite valeur d'index établie pour le bloc étant appliquée au multiplexeur comme entrée de sélection de voie d'entrée (Sel(vⱼ)), pour sélectionner un retard parmi N,
tel que pour un bloc de rang j dans la succession de blocs, j entier, égal de 1 à N, un signal numérique transmis par une ligne conductrice respective et reçu en entrée (INcⱼ) de ce bloc (Bⱼ) après avoir traversé les j-1 blocs précédents de la suite, est appliqué sur le noeud interne de ce bloc avec un retard incrémenté de Δt par rapport au retard appliqué dans le bloc de rang suivant j+1 ou décrémenté de Δt par rapport au retard appliqué dans le bloc de rang précédent j-1.

6. Circuit électronique selon la revendication 5, comprenant M lignes conductrices transportant M signaux numériques différents à travers les N blocs de la suite, qui sont appliqués sur M noeuds électriques internes dans chacun des N blocs de la suite, à travers M circuits de temporisation identiques, et les M circuits de temporisation dans chacun des N blocs reçoivent le même signal d'index.

7. Circuit électronique selon la revendication 5, dans lequel le bloc reçoit N signaux numériques différents parmi lesquels un seul signal de rang j doit être appliqué à un noeud électrique interne du bloc de rang j, par le circuit de temporisation du bloc, le bloc comprenant en outre un circuit de routage des N signaux numériques à l'intérieur de chaque bloc, entre N plots d'entrée i₁ à i_{N} et N plots de sorties o₁ à o_{N}, du bloc, les plots d'entrée et de sortie de routage de même rang étant alignés sur les N blocs, et chacun des N plots de sortie d'un bloc étant relié au plot d'entrée de même rang du bloc suivant, le circuit de routage étant identique dans chacun des N blocs de la suite et tel que :
- un premier plot d'entrée (i₁) du bloc est connecté en entrée d'un circuit de temporisation du bloc ;
- les N-1 autres plots d'entrée du bloc (i₂ à i_{N}) sont connectés aux N-1 premiers plots de sortie du bloc (o₁ à o_{N-1}), tel que le plot d'entrée ayant le rang k, où k=2 à N, est connecté au plot de sortie de rang k-1 ; et
- le N-ième plot de sortie (o_{N}) de routage du bloc est référencé à une référence interne de tension.

8. Circuit selon l'une des revendications 5 à 7, dans lequel les N blocs de la suite comprennent un circuit pour incrémenter le signal d'index, et ce circuit est un circuit d'incrémentation lorsque le signal d'index est propagé dans le même sens que le ou les signaux numériques, et un circuit de décrémentation lorsqu'il est propagé dans le sens inverse.

## Patentansprüche

1. Verfahren zum Verteilen von digitalen Signalen zu jedem der Blöcke eines ausgerichteten Satzes von N identischen benachbarten Blöcken einer elektronischen Schaltung über Signalleitungen, die die N Blöcke entlang einer Ausrichtungsachse der Blöcke durchqueren, wobei die Durchquerung der einzelnen N Blöcke eine elementare Verzögerung Δt einführt, **dadurch gekennzeichnet, dass** das Verfahren Folgendes beinhaltet:
- eine automatische Indexierung der Blöcke durch Propagierung eines Indexsignals (ID) durch die N Blöcke mit einer Inkrementierung oder Dekrementierung des Indexwertes bei der Passage in jedem Block, wobei die automatische Indexierung einen jeweiligen Indexwert für jeden der N Blöcke des Satzes festlegt,
- ein Signal-Timing, angewendet am Eingang jedes Blocks, zwischen einer Leitung eines Signals und einem internen elektrischen Signalanlegeknoten, wobei die angewendete Timing-Dauer anhand des für diesen Block festgelegten Indexwertes aus N unterschiedlichen Timing-Dauern ausgewählt wird, getrennt durch ein Inkrement von elementarer Dauer Δt, das der elementaren Verzögerung Δt der Durchquerung eines in eine Leitung eingeführten Blocks entspricht,
und dadurch, dass dieses Timing mittels einer blockweisen Timing-Schaltung erfolgt, die für jeden Block identisch ist, geschaltet zwischen dem Eingang und dem internen Knoten des Blocks, und die N Verzögerungsschaltungen zum Liefern der N Timing-Dauern umfasst, wobei die Verzögerungsschaltungen jeweils zwischen dem Eingang des Blocks und einem jeweiligen Eingangskanal eines Multiplexers mit N Eingangskanälen und einem Ausgangskanal geschaltet sind, wobei das Ausgangssignal mit dem internen Knoten des Blocks verbunden ist und wobei der für den Block festgelegte Indexwert auf den Multiplexer als Auswahleingang des Eingangskanals (Sel(vⱼ) angewendet wird, wobei das Verfahren derart ist, dass für jedes j, wobei j eine ganze Zahl von 1 bis N ist, ein von einer jeweiligen Leitung übertragenes und am Eingang (INcⱼ) des j-ten Blocks (Bⱼ) des Satzes nach dem Durchqueren der j-1 vorhergehenden Blöcke des Satzes empfangenes digitales Signal an den internen Knoten dieses Blocks mit einem Timing um Δt größer als das entsprechende Timing im (j+1)-ten Block oder um Δt kleiner als das entsprechende Timing im (j-1)-ten Block angelegt wird.

2. Verteilungsverfahren nach Anspruch 1, angewendet auf die Verteilung von M digitalen Signalen, wobei M eine ganze Zahl wenigstens gleich 1 ist, wobei jedes der M digitalen Signale auf einen entsprechenden internen elektrischen Knoten in jedem der N Blöcke des Satzes verteilt wird, **dadurch gekennzeichnet, dass** das Timing jedes der M digitalen Signale in jedem der N Blöcke des Satzes durch M identische Timing-Schaltungen in jedem der N Blöcke erfolgt, die das eine Verzögerung unter N Verzögerungen auswählende Indexsignal (ID) empfangen.

3. Verteilungsverfahren nach Anspruch 1, angewendet auf die Verteilung von N digitalen Signalen durch N Leitungen, die die N Blöcke des Satzes durchqueren, wobei jedes der N digitalen Signale an einen internen elektrischen Knoten eines jeweiligen einzigen Blocks des Satzes von N Blöcken angelegt wird, **dadurch gekennzeichnet, dass** es ferner ein Routing von N Signalen im Innern jedes Blocks, für jeden Block identisch, zwischen N Eingangsanschlüssen i₁ bis i_{N} und N Ausgangsanschlüssen o₁ bis o_{N} des Blocks beinhaltet, wobei die Routing-Ein- und -Ausgangsanschlüsse desselben Rangs auf den N Blöcken ausgerichtet sind, und die N Ausgangsanschlüsse eines Blocks mit den N Eingangsanschlüssen des Folgeblocks entsprechend verbunden sind, wobei das Routing ins Innere jedes Blocks derart ist, dass:
- ein erster Eingangsanschluss (i₁) des Blocks am Eingang einer Timing-Schaltung des Blocks angeschlossen ist;
- die N-1 anderen Eingangsanschlüsse des Blocks (i₂ bis i_{N}) mit den N-1 ersten Ausgangsanschlüssen des Blocks (o₁ bis o_{N-1}) verbunden sind, so dass der Eingangsanschluss von Rang k, wobei k=2 bis N ist, mit dem Ausgangsanschluss von Rang k-1 verbunden ist; und
- der N-te Ausgangsanschluss (o_{N}) des Routings des Blocks auf eine interne Spannungsreferenz referenziert ist.

4. Verfahren nach einem der Ansprüche 1 bis 3, in dem das Indexsignal um eine Einheit bei der Passage in jedem Block inkrementiert wird, wenn es in derselben Richtung propagiert wie die ein oder mehreren digitalen Signale, oder um eine Einheit dekrementiert wird, wenn es in umgekehrter Richtung propagiert.

5. Elektronische Schaltung, die wenigstens einen ausgerichteten Satz von N identischen benachbarten Blöcken und einen oder mehrere Leitungen umfasst, die die N Blöcke entlang der Ausrichtungsachse der Blöcke durchqueren, so dass wenigstens ein digitales Signal an einen Eingang jedes der N Blöcke des Satzes angelegt werden kann, um dieses Signal auf einen jeweiligen internen elektrischen Knoten des Blocks zu übertragen, **dadurch gekennzeichnet, dass** jeder Block Folgendes umfasst:
- einen Indexsignaleingang zum Empfangen eines Indexsignals (ID) und zum Propagieren durch die N Blöcke, mit einer Inkrementierung oder Dekrementierung des Indexwertes bei der Passage in dem Block, um einen jeweiligen Indexwert für jeden der N Blöcke des Satzes festzulegen,
- eine Signal-Timing-Schaltung pro Block, für jeden Block identisch, und zwischen dem Eingang des Blocks und dem internen elektrischen Knoten des Blocks geschaltet, wobei die Timing-Schaltung N Verzögerungsschaltungen zum Liefern einer Serie von N unterschiedlichen Timing-Dauern umfasst, getrennt durch ein Inkrement von elementarer Dauer Δt, das der elementaren Verzögerung Δt der Durchquerung eines in eine Leitung eingeführten Blocks entspricht,
wobei die N Verzögerungsschaltungen jeweils zwischen dem Eingang des Blocks und einem jeweiligen Eingangskanal eines Multiplexers mit N Eingangskanälen und einem Ausgangskanal geschaltet sind, wobei der Ausgangskanal mit dem internen Knoten des Blocks verbunden ist und wobei der für den Block festgelegte Indexwert auf den Multiplexer als Auswahleingang des Eingangskanals (Sel(vⱼ)) angewendet wird, um eine Verzögerung aus N auszuwählen,
so dass für einen Block von Rang j in der Folge von Blöcken, wobei j eine ganze Zahl von 1 bis N ist, ein digitales Signal, übertragen von einer jeweiligen Leitung und empfangen am Eingang (INcⱼ) dieses Blocks (Bⱼ) nach dem Durchqueren der j-1 vorherigen Blöcke des Satzes, an den internen Knoten dieses Blocks mit einer um Δt inkrementierten Verzögerung mit Bezug auf die im Block des folgenden Rangs (j+1) angewendete Verzögerung oder dekrementiert um Δt mit Bezug auf die im Block des vorherigen Rangs j-1 angewendete Verzögerung angelegt wird.

6. Elektronische Schaltung nach Anspruch 5, die M Leitungen umfasst, die M unterschiedliche digitale Signale durch die N Blöcke des Satzes, die an M interne elektronische Knoten in jedem der N Blöcke des Satzes angelegt werden, durch M identische Timing-Schaltungen transportieren, und die M Timing-Schaltungen in jedem der N Blöcke dasselbe Indexsignal empfangen.

7. Elektronische Schaltung nach Anspruch 5, in der der Block N unterschiedliche digitale Signale empfängt, von denen ein einziges Signal von Rang j an einen internen elektrischen Knoten des Blocks von Rang j angelegt werden muss, durch die Timing-Schaltung des Blocks, wobei der Block ferner eine Schaltung zum Routen von N digitalen Signalen im Innern jedes Blocks umfasst, zwischen N Eingangsanschlüssen i₁ bis i_{N} und N Ausgangsanschlüssen o₁ bis o_{N} des Blocks, wobei die Routing-Ein- und - Ausgangsanschlüsse desselben Rangs mit den N Blöcken ausgerichtet sind, und jeder der N Ausgangsanschlüsse eines Blocks mit dem Eingangsanschluss desselben Rangs des Folgeblocks verbunden ist, wobei die Routing-Schaltung in allen der N Blöcke des Satzes identisch ist, und so, dass:
- ein erster Eingangsanschluss (i₁) des Blocks am Eingang einer Timing-Schaltung des Blocks verbunden ist;
- die N-1 anderen Eingangsanschlüsse des Blocks (i₂ bis i_{N}) mit den N-1 ersten Ausgangsanschlüssen des Blocks (ο₁ bis o_{N-1}) verbunden sind, so dass der Eingangsanschluss mit Rang k, wobei k=2 bis N ist, mit dem Ausgangsanschluss von Rang k-1 verbunden ist; und
- der N-te Ausgangsanschluss (o_{N}) des Routings des Blocks auf eine interne Spannungsreferenz referenziert ist.

8. Schaltung nach einem der Ansprüche 5 bis 7, in dem die N Blöcke des Satzes eine Schaltung zum Inkrementieren des Indexsignals umfassen und diese Schaltung eine Inkrementierungsschaltung ist, wenn das Indexsignal in derselben Richtung propagiert wie die ein oder mehreren digitalen Signale, und eine Dekrementierungsschaltung ist, wenn es in der entgegengesetzten Richtung propagiert.

## Claims

1. Method for distributing a digital signal to each of the blocks of an aligned succession of N identical adjacent blocks of an electronic circuit, by means of conductive signal lines transiting the N blocks along the alignment axis of the blocks, the transit through each of the N blocks introducing an elementary delay Δt, **characterized in that** the method comprises
- an automatic indexing of the blocks by means of propagation of an index signal (ID) through the N blocks, with incrementation or decrementation of the index value on passage through each block, said automatic indexing setting a respective index value for each of the N blocks of the succession,
- a signal timing delay applied to the input of each block, between a conductive line for a signal and an internal electrical node for application of said signal, and the applied timing delay time is selected by means of the index value set for this block, from N different timing delay times separated by an increment of elementary duration Δt that corresponds to the elementary delay Δt for transit of a block introduced into a conductive line,
and **in that** this timing delay is implemented by means of one timing delay circuit per block, which is identical for each block, that is connected between the input and the internal node of the block, and that comprises N delay circuits in order to supply the N timing delay times, said delay circuits each being connected between the input of the block and a respective input channel of a multiplexer having N input channels and one output channel, said output channel being connected to the internal node of the block, and said index value set for the block being applied to the multiplexer as an input channel selection input (Sel(vⱼ), said method being such that for any j, j an integer from 1 to N, a digital signal transmitted by a respective conductive line and received at the input (INcⱼ) of the j-th block (Bⱼ) of the succession after having transited the j-1 previous blocks of the succession, is applied to the internal node of this block with a timing delay that is greater by Δt than the corresponding timing delay in the (j+1)-th block or less by Δt than the corresponding timing delay in the (j-1)-th block.

2. Distribution method according to Claim 1, applied to the distribution of M digital signals, M an integer at least equal to 1, where each of the M digital signals is distributed to a corresponding internal electrical node in each of the N blocks of the succession, **characterized in that** the timing delay of each of the M digital signals in each of the N blocks of the succession is provided by M identical timing delay circuits in each of the N blocks, receiving the index signal (ID) selecting a delay from N delays.

3. Distribution method according to Claim 1, applied to the distribution of N digital signals by N conductive lines transiting the N blocks of the succession, where each of the N digital signals is applied to an internal electrical node of a single respective block of the succession of N blocks, **characterized in that** it moreover comprises a routing of the N signals inside each block, which is identical for each block, between N input pads i₁ to i_{N} and N output pads o₁ to o_{N} of the block, the routing input and output pads of the same rank being aligned on the N blocks, and the N output pads of a block being connected to the N input pads of the next block, correspondingly, said routing inside each block being such that:
- a first input pad (i₁) of the block is connected to the input of a timing delay circuit of the block;
- the other N-1 input pads of the block (i₂ to i_{N}) are connected to the first N-1 output pads of the block (o₁ to o_{N-1}), such that the input pad having the rank k, where k=2 to N, is connected to the output pad of rank k-1; and
- the N-th routing output pad (o_{N}) of the block is referenced to an internal voltage reference.

4. Method according to one of Claims 1 to 3, in which the index signal is incremented by one unit on passage through each block when it is propagated in the same direction as the digital signal(s), or decremented by one unit when it is propagated in the opposite direction.

5. Electronic circuit having at least one aligned succession of N identical adjacent blocks and one or more conductive lines transiting the N blocks along the alignment axis of the blocks, which allow application of at least one digital signal to an input of each of the N blocks of the succession for the purpose of transmitting this signal to a respective internal electrical node of the block, **characterized in that** each block comprises
- an index signal input for receiving an index signal (ID) and propagating it through the N blocks, with incrementation or decrementation of the index value on passage through the block, in order to set a respective index value for each of the N blocks of the succession,
- one signal timing delay circuit per block, which is identical for each block, and connected between the input of the block and the internal electrical node of the block, the timing delay circuit comprising N delay circuits in order to supply a series of N different timing delay times separated by an increment of elementary duration Δt that corresponds to the elementary delay Δt for transit of a block introduced into a conductive line,
the N delay circuits each being connected between the input of the block and a respective input channel of a multiplexer having N input channels and one output channel, said output channel being connected to the internal node of the block, and said index value set for the block being applied to the multiplexer as an input channel selection input (Sel(vⱼ)), in order to select a delay from N,
such that, for a block of rank j in the succession of blocks, j an integer, equal to 1 to N, a digital signal transmitted by a respective conductive line and received at the input (INcⱼ) of this block (Bⱼ) after having transited the j-1 previous blocks of the succession, is applied to the internal node of this block with a delay incremented by Δt in relation to the delay applied in the block of next rank j+1 or decremented by Δt in relation to the delay applied in the block of previous rank j-1.

6. Electronic circuit according to Claim 5, comprising M conductive lines transporting M different digital signals through the N blocks of the succession, which are applied to M internal electrical nodes in each of the N blocks of the succession, through M identical timing delay circuits, and the M timing delay circuits in each of the N blocks receive the same index signal.

7. Electronic circuit according to Claim 5, in which the block receives N different digital signals from which a single signal of rank j needs to be applied to an internal electrical node of the block of rank j, by the timing delay circuit of the block, the block moreover comprising a circuit for routing the N digital signals inside each block, between N input pads i₁ to i_{N} and N output pads o₁ to o_{N}, of the block, the routing input and output pads of the same rank being aligned on the N blocks, on each of the N output pads on a block being connected to the input pad of the same rank of the next block, the routing circuit being identical in each of the N blocks of the succession and such that:
- a first input pad (i₁) of the block is connected to the input of a timing delay circuit of the block;
- the other N-1 input pads of the block (i₂ to i_{N}) are connected to the first N-1 output pads of the block (o₁ to o_{N-1}), such that the input pad having the rank k, where k=2 to N, is connected to the output pad of rank k-1; and
- the N-th routing output pad (o_{N}) of the block is referenced to an internal voltage reference.

8. Circuit according to one of Claims 5 to 7, in which the N blocks of the succession comprise a circuit for incrementing the index signal, and this circuit is an incrementation circuit when the index signal is propagated in the same direction as the digital signal(s), and a decrementation circuit when it is propagated in the opposite direction.
